# EUROPEAN PATENT SPECIFICATION

(11) **EP 1 693 891 B1**
(45) Date of publication and mention of the grant of the patent: **31.07.2019**
(21) Application number: 06447017.2
(22) Date of filing: 31.01.2006
(51) Int. Cl.: H01L 21/68, H01L 21/768, H01L 23/48, H01L 29/417, H01L 23/367

(54) **METHOD OF MANUFACTURING A SEMICONDUCTOR DEVICE**
VERFAHREN ZUR HERSTELLUNG EINER HALBLEITERANORDNUNG
PROCEDE DE FABRICATION D'UN DISPOSITIF À SEMI-CONDUCTEUR

(30) Priority: 31.01.2005 US 648841 P; 30.06.2005 EP 05447156
(43) Date of publication of application: 23.08.2006
(73) Proprietor: IMEC VZW, 3001 Leuven (BE)
(72) Inventor: Das, Johan, 3000 Leuven (BE); Ruythooren, Wouter, 3150 Tildonik (BE)
(74) Representative: Pronovem

(56) References cited:
- WO-A-2004/109770
- GB-A- 2 046 514
- US-A1- 2002 030 267
- SHEPPARD S T ET AL: "High power demonstration at 10 GHz with GaN/AlGaN HEMT hybrid amplifiers" DEVICE RESEARCH CONFERENCE, 2000. CONFERENCE DIGEST. 58TH DRC JUNE 19-21, 2000, PISCATAWAY, NJ, USA,IEEE, 19 June 2000 (2000-06-19), pages 37-38, XP010517447 ISBN: 0-7803-6472-4

## Description

### Field of the Invention

The present invention is related to methods for producing semiconductor devices comprising multiple source-gate-drain or collector-base-emitter combinations, in particular devices that are designed to work at high frequency and high power levels, such as multiple gate-finger High Electron Mobility Transistors (HEMTs), i.e. having at least two gate contacts on the same substrate.

### State of the Art

High frequency and power devices are generally confronted by a problem of thermal management. In HEMT-devices, heat is generated in a very small area, especially in the channel, close to the gate area. This heat needs to be removed in an effective way.

An established way to produce multiple gate-finger HEMTs is to grow a semiconductor stack (e.g. a GaN/AlGaN stack) on a first substrate, for instance a sapphire substrate, provide ohmic contacts, gate metal and contact metal and a passivation layer, and apply a structure on top of the device, called an 'airbridge', to connect the neighbouring contacts, with similar function. Flip chip bumps are then applied around the HEMT or on a second substrate. The first substrate is then diced to form individual devices which are subsequently attached to the second substrate by flip-chip technology. The air bridges collect the heat generated in the HEMT and remove it laterally. The heat is further removed in vertical direction by the flip-chip bumps. This however results in a device with a considerable height.

In US2003/0040145A1, a method is described for transferring and stacking semiconductor devices. The method allows to produce a single-gate HEMT device by forming it on a first substrate, singulating the first substrate into separate devices, and attaching the individual devices to a second substrate, via a bonding layer. It is not a self-evident step to apply a similar method to multiple gate-finger HEMTs, given that the interconnect between neighbouring contacts would need to be provided in a different way, compared to the air-bridge structures.

US2001/0005043 is related to a semiconductor device and a method of manufacturing the same, wherein a plurality of bipolar transistors are produced on a substrate. The substrate is flipped onto a secondary substrate, and the active areas of the devices are connected through a metal layer applied to the backside of the device, after creation of via holes. The transistors are subsequently diced, to form individual single-gate devices, eg. HEMTs. Given that there is no need in this disclosure for interconnecting corresponding area's (e.g. bases) of the different transistors, to produce a single (e.g. multiple base) device, the problem of avoiding airbridges is not addressed in this document.

Document US6214639 describes a multi-finger HEMT, wherein the source, gate and drain areas are contacted from the backside of the device, by producing through holes to lateral areas which are connected to the multiples sources, drains and gates of the device. However, this technique requires at least one air-bridge to be made. This is shown in figure 1a of US6214639, by the dotted lines on the area 14, representing the gate contact area. At these dotted lines, the gate area is crossed by the area's 12. On these locations, air bridges are necessary to separate the contact areas 12 and 14.

Document US2005/0127397 describes a GaN device with heat spreading layer and a thermal via. However, the problem of avoiding airbridges is not addressed here. The heat sinks are moreover not used to interconnect different regions of the device. GB 2046514 A describes a semiconductor device comprising a plurality of groups of contacts, each group of contacts consist of a source contact, a drain contact and a gate contact.

### Aims of the Invention

The present invention aims to provide methods for producing semiconductor devices, in particular high frequency and high power devices such as multiple gate-finger HEMTs, which are more compact than the air-bridge structures known in the art, and which are still within the required specifications in terms of heat dissipation.

### Summary of the Invention

The invention is related to methods as described in the appended claims. As expressed in independent method claims 1 and 4, the invention is related to methods for producing a semiconductor device comprising a plurality (i.e. at least two) of groups of gate/drain/source contacts, or equivalently, base/collector/emitter contacts, wherein the respective types of contact of said groups are interconnected to a common gate, drain and source (or base, collector, emitter) output contact. The preferred embodiments are a multiple gate-finger HEMT, and a multiple base bipolar transistor. In all of the following description, and for the sake of conciceness of the text, the words 'gate,source,drain' contacts will be used. It is however to be noted that these words can be replaced everywhere by 'base, emitter, collector' respectively.

The basic characteristic of the invention is expressed in appended independent method claims 1 and 4. A first substrate is provided, comprising on its front side a semiconductor stack, i.e. a semiconductor layer, and on top of that layer a plurality of gate contacts, each gate contact lying in between source and drain ohmic contacts, for producing a plurality of source-gate-drain structures. After flipping the first substrate onto a second substrate, the device is then contacted from the backside (the side opposite the one carrying the gate/source/drains), by etching via's through the semiconductor layer and through the first substrate itself. The first substrate is completely removed after flipping the device onto a second substrate, and vias are etched in the semiconductor layer.

In all embodiments, the vias are etched in a particular way with respect to the above mentioned contacts. The term 'ohmic contacts' refers to the contact regions which form a direct ohmic contact with the active area's defined as source and drain on the semiconductor layer.

According to the invention, vias are produced directly on top of each contact of at least one type, e.g. on top of all the source ohmic contacts, to thereby expose said ohmic contact, so that it may be contacted by a subsequently applied interconnect layer. At least one type of contact (e.g. all the source ohmic contacts) is contacted directly in this way. The other types of contacts may be contacted in another way, e.g. by providing vias to lateral contact areas (i.e. via's which are not directly on top of the actual ohmic contacts). Alternatively, two types of contact (preferably sources and drains), may all be contacted directly through via holes produced directly on top of these types of contact.

By providing via's directly on top of at least one type of contact, and by thus contacting directly the (ohmic) contacts of that type, it is not necessary to apply an airbridge in order to accomplish the necessary interconnections. This will be explained in more detail with reference to the drawings.

The method of the invention comprises the following basic steps :
- providing a first substrate, comprising on its front side a semiconductor stack, i.e. a semiconductor layer, and on top of that layer a plurality of gate contacts, each gate contact lying in between source and drain contacts (ohmic contacts), for producing a plurality of source-gate-drain structures,
- providing a second substrate provided with an adhesive layer,
- attaching the first substrate to the second substrate, by attaching the front side of that substrate to the adhesive layer on the second substrate. If no additional layers are deposited over the gate contacts, this means that the gate contacts are brought in direct contact with the adhesive layer.
- Removing the first substrate from the semiconductor layer, after the step of attaching the first substrate, to expose the backside of the semiconductor layer,
- Etching vias through the semiconductor layer, in the way described above,
- producing on the semiconductor layer an interconnecting contact layer to provide an interconnect between said source-gate-drain structures. This results in an operational device on the second substrate.
The last two steps constitute a backside contacting step of the final device, with a particular way of producing vias with respect to the ohmic contacts, which is the main distinguishing feature compared to the prior art, where the interconnect between the source/gate/drain structures (for multi-gate devices) is established by air-bridge structures. Preferably, a contact metal layer is produced onto said contacts, prior to attaching the first substrate to the second.

The method of the invention is applicable to a multiple gate-finger (in short: multi-finger) HEMT device, which is the preferred embodiment described in detail hereafter. However, the invention is applicable to any plurality of interconnected source-gate-drain structures, whether they are adjacent in one area of the substrate, or located in different areas of the substrate.

The first substrate may be a sapphire, silicon or a glass substrate. It may also be a GaAs, Ge, InP, SiC or AIN substrate. The second substrate is preferably a low cost substrate. It may be a glass, silicon or polymer based substrate. According to a further embodiment, the second substrate may be a multi-chip-module dielectric stack (MCM-D). The MCM-D stack may comprise passive components such as resistors or capacitors. The removal of the first substrate can be performed by wet etching, dry etching, laser ablation or laser lift-off (or a combination of these techniques).
The semiconductor layer may be made of a Group III nitride material. A group III nitride material is a material comprising a nitride of an element of Group III of the periodic table of elements. Group III nitride materials are known to a person skilled in the art as wide band gap materials. A group III nitride material can be GaN, whereby GaN is to be understood as a material comprising at least GaN, such as, but not limited hereto, AIGaN, InGaN, AlInGaN, GaAsPN and the like. The semiconductor layer can also comprise a stack of layers, wherein at least one of the layers comprising a group III nitride material. The device as recited in this invention can also comprise a diamond layer instead of a Group-III nitride material.
In another preferred embodiment, the source contact and drain contact are made of an alloy comprising Ti, Al, Ni, Mo, Ta, Pt, Pd, Si, V, Nb, Zr and/or Au. The contact being preferably formed by Ti/Al/Ti/Au sequence, Ti/Al/Ni/Au, Ti/Al/Mo/Au or Ti/Al/Pt/Au

The adhesive layer is preferably produced from a thermally conductive adhesive, for the purpose of obtaining sufficient heat dissipation in the final device. The adhesive can be selected from the group consisting of organic polymers, SU-8, poly-imide, BCB, silicones, flowable oxides, thermally conductive epoxy, e.g. epoxies with fillers (suspended particles to enhance thermal conductivity). The thickness of the thermally conductive adhesive layer is preferably between 500nm and 10 µm even more preferably between 500nm and 1 µm.

According to a preferred embodiment, a layer with the combined function of passivation and heat spreading, may be deposited on the gate/source/drain contacts on the first substrate, prior to attaching the first substrate to the second. This passivation and heat spreading layer has two functions:
- to protect gates and exposed semiconductor surface and to improve the electrical properties of said surface,
- to spread the heat in order to minimize the thermal resistance of the adhesive layer
This passivation and heat spreading layer is a layer with a high thermal conductivity (higher than 150W/mK). During the attaching step, it is then the heat spreading layer which is attached to the thermally conductive adhesive layer. In this case, the thermally conductive adhesive layer can be the same as in the previous embodiment. However, since the thermal conductivity of the heat spreading layer is preferably better than typical adhesive layers (<10W/mK), the application of a heat spreading layer further improves the thermal performance. The passivation and heat spreading layer may be formed of AIN, AlSiC, highly resistive Si, SiC or Si-nitride or diamond. Advantageously, a combination of two subsequent layers, a first layer as a passivation layer and a second as a heat spreading layer, can be used to have an optimal performance.

After via-etching and before backside contacting, a second passivation layer may be applied onto the semiconductor layer.

An advantage of the present invention is that the active side of the semiconductor device is protected and remains essentially unaffected. A further advantage is that the resulting structure is more compact, compared to devices produced by applying air bridge structures. The device produced according to the present invention is highly integrated, has short interconnects and a planar character, allowing further 3D integration.

The method comprises a number of further steps. After the connection between the source/gate/drain structures has been established, the second substrate, which is now carrying the finished interconnected device, is reversed and attached to a third substrate, by attaching the side of the second substrate, carrying the interconnect layer, to the third substrate, preferably an MCM substrate. The second substrate and the original adhesive layer are then removed, and vias can be etched and heat sinks applied which allow for a better heat dissipation. This will be described in more detail for a multi-finger HEMT device.

According to an example not falling within the scope of the claimed invention, the first substrate is not attached to a second substrate. The via's are produced through the backside of the first substrate, to expose e.g. the source areas. Possibly, the substrate may be subjected to a thinning operation prior to the via etching. After formation of the via's (in the way described in independent method claims 1 and 4), and application of the contacting layer, the first substrate may then be attached to a second substrate (equivalent to the third substrate from the previous embodiment).

To summarize, the advantages of the present invention are :
- Additional thermal conduction paths to the active device are created : this means that the heat can be removed both vertically (towards the 2^{nd} substrate, e.g. MCM) and laterally (by means of the metal contacts). The vertical distance between device and substrate is small, which limits the thermal resistance of this conduction path.
- Airbridges on the semiconductor substrate are avoided,
- The electrical connections to the HEMT are very short ; this means that there are less parasitics and as a result an improved RF-behaviour,
- The final structure is very planar ; this may facilitate further packaging and system integration.
Moreover, the advantages associated with MCM remain valid:
- MCM is better suited for greater metal thickness (improving the thermal conductivity)
- The devices can be tested before the MCM integration
- MCM adds functionality to the device through passives or integration of several active components possibly obtained from different technologies.
- Lower substrate cost compared to MMIC

### Brief Description of the Drawings

Fig. 1 illustrates method steps to produce a multi-finger HEMT.
Fig. 2 illustrates the steps of the method according to the invention.
Fig. 3 shows a top view of a HEMT device, illustrating the shape of the contact areas in a preferred embodiment of the device.
Fig. 4a and 4b show alternative designs for a 6 gate HEMT according to the invention.
Fig. 5a and 5b show more alternative designs for a 6-gate HEMT according to the invention.
Fig. 6 shows the steps of an alternative method not according to the invention.
Fig. 7 shows a number of alternative patterns for the interconnecting layer according to the invention.

### Description of a Preferred Embodiment of the Invention

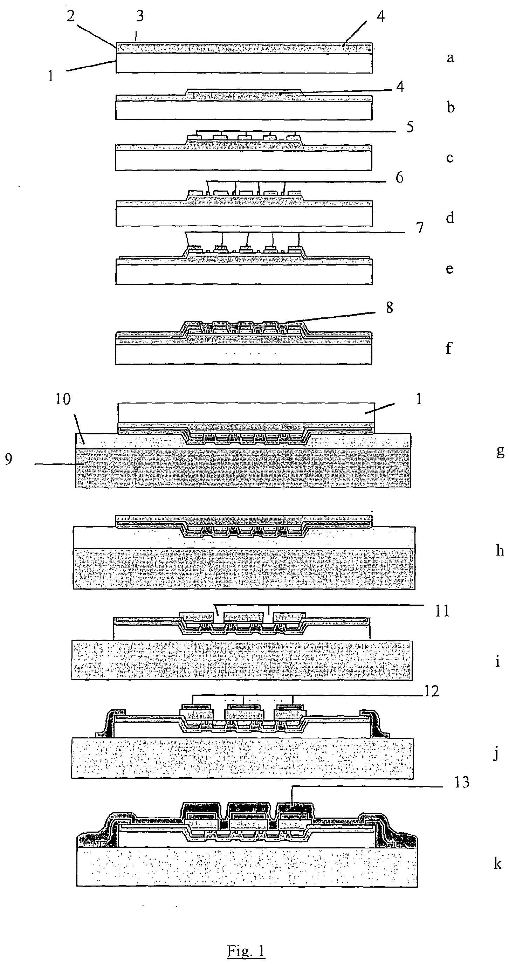

The preferred embodiment of the present invention concerns the production of a multi-finger HEMT device according to the method as characterised above. In figure 1, the different process steps of producing a HEMT are illustrated. The steps will be further highlighted hereafter.

Fig. 1a : providing a sapphire substrate 1, with a semiconductor stack on top of it. The stack consists of a GaN layer 2 and an AIGaN layer 3. The GaN film is between 1 and 5 µm thick and grown on the sapphire substrate in a MOCVD system (Metal Organic Chemical Vapour Deposition). The top layer 3 of AIGaN (15-30nm) film is grown on top such that a high concentration of electrons occurs at the interface (two dimensional electron gas, 2-DEG).

Fig. 1b : a mesa etch is done to isolate individual devices on the substrate. The etch has to go through the 2-DEG interface 4.

Fig. 1c : A metal stack 5 is deposited for the drain and source ohmic contacts. The source and drain contacts are deposited together. A typical stack is Ti/Al/x/Au (x=Mo, Pt, Ti,...), with thickness respectively : 20/40/25/50nm. The thickness of the layers is optimised depending on the GaN/AlGaN layer. An annealing at high temperature is performed to promote alloy formation that makes the contacts ohmic in nature (at 800-1000°C).

Fig. 1d : The gate contacts 6 are produced with a an e-beam process; the material used for the gates may be Ni/Au or Pt/Au (20/200nm).

Fig. 1e : optionally, a contact metal layer 7 is applied (e.g TiW/Au/TiW).

Fig. 1f : a passivation layer is deposited over the device (100nm Si3N4, not visible on figure) and a heat spreading layer 8 is deposited over the passivation layer (e.g. 0.5-1 µm AlN). After this step, the substrate 1 is preferably diced to form individual devices.

Fig. 1g : a second substrate 9 is provided, with a thermally conductive adhesive layer 10 on said second substrate. There may be passive components present on the second substrate. The HEMT device and first substrate are reversed and bonded to the adhesive layer, so that the heat spreading layer 8 is in direct contact with the adhesive layer 10. The adhesive used may be BCB or SU-8.

Fig. 1h : the first substrate is removed, possibly using laser lift-off: laser pulses are applied to the sapphire substrate, the pulses having an energy higher than the GaN bandgap. The pulses are absorbed at the GaN/sapphire interface, which leads to a local decomposition into Ga and N2. Ga has a very low melting point: this means that the substrate can be removed at low temperature. The remaining Ga can be removed by a short HCI-dip.

Fig. 1i : Around the HEMT device, the adhesive layer is removed using a SF6/O2 etch. Vias 11 are made in the GaN/AlGaN active layer using Cl2-etching.

In the drawing in fig. 1i, the vias are etched to expose the source, drain and gate contacts to the environment (i.e. uncover these contacts) so that these source contacts may be directly contacted in the next process step.

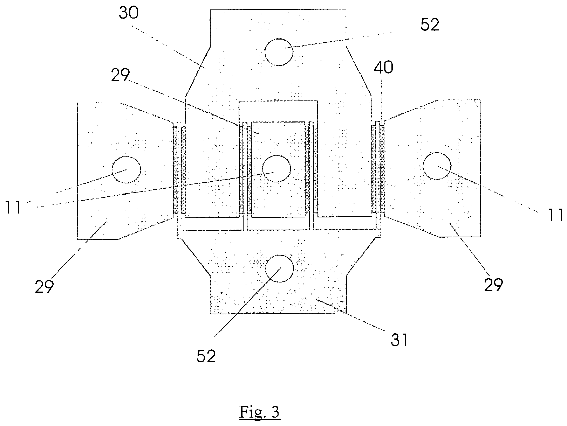

The section of fig. 1i shows vias only to the source contacts. However, the gates and drains need to be contacted as well : Fig. 3 shows a top view of the HEMT device of figure 1, including the mesa 40 and the location where the vias 11 are produced. The source contact areas 29 are contacted directly, while the drain and gate areas are produced in such a way that they are interconnected to lateral contact areas 30 and 31, each contacted through one via 52. It is to be noted that it is not a limitation of the invention that the source contacts are to be contacted directly (i.e. as shown in fig. 3). This may equally be the case for the gate or drain contacts, in which case the remaining two contacts may be contacted through lateral areas in the plane of the device. Still alternatively, all contact areas may be contacted directly, i.e. without the lateral contact areas.

Fig. 1j : optionally, a passivation layer 12 is deposited onto the backside, e.g. Si-nitride. This layer passivates the GaN backside and may influence the electronic properties of the HEMT.

Fig. 1k : a contact layer 13 to the gate/source/drain contacts is deposited, e.g. using Cu-electroplating.

These steps result in a multi-finger HEMT device.

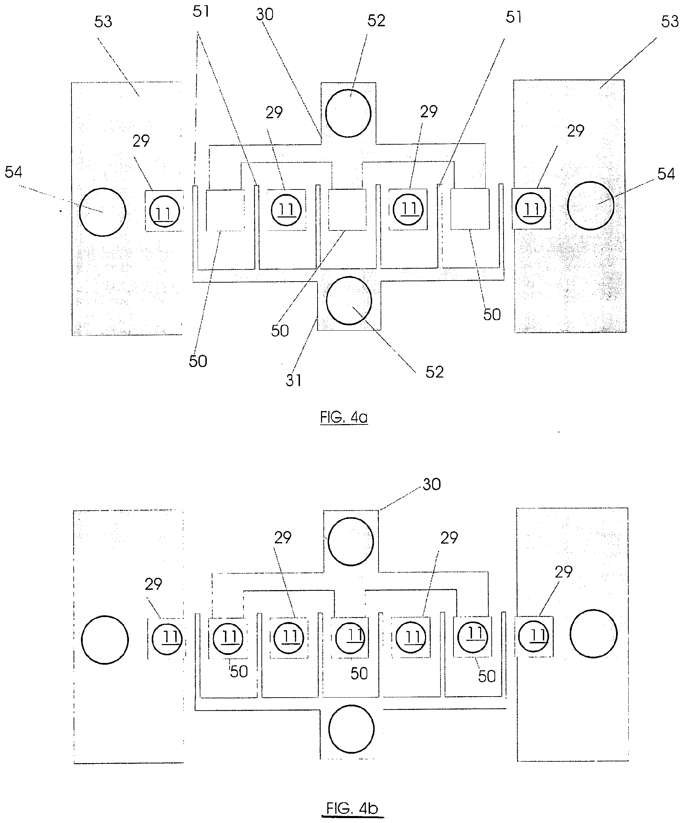

As stated above, the invention is characterized by the fact that vias 11 are produced to *directly* contact at least one of the types of ohmic contact of the device. Figures 4a and 4b show a number of alternatives in case of a 6-gate HEMT. The contours are shown of what is defined as the 'ohmic contacts' of the sources (29) and drains (50). The gate contacts 51 are visible as well. In fig. 4a, vias 11 are etched directly on top of the source contacts 29, to expose these contacts, so that they may be interconnected by the interconnect layer 13 (fig. 1). Directly on top of the drain and gate contacts, no vias are produced. In stead, these contacts are contacted via lateral areas 30 and 31 (also called contact pads), wherein one via 52 is produced respectively. In the device of figure 4a, contact pads 53 are also shown which are in connection with the outer two source area's. Additional vias 54 may be produced on these outer contact pads. However, the latter is not a requirement of the present invention.

In the embodiment in figure 4b, vias 11 are produced to directly contact all the source and drain areas 29 and 50. The contact pad 30 for the drains is still present, but could be omitted in this embodiment. Alternatively, vias 11 may be produced to directly contact all types of contact (sources, drains and gates). In this case, it would be necessary to produce gates with a broader width.

In the embodiments shown in figures 3 and 4, it is clear that the interconnecting layer 13, properly patterned, is able to interconnect the source regions 29 with each other, as well as the drain and gate regions 50,51 respectively, without the necessity of interconnecting one type of contact (e.g. all the drains) by an airbridge. An airbridge would be necessary if all of the contact types would be contacted through a lateral contact pad, as in US6214639. This illustrates the improvement accomplished by the invention over the available art.

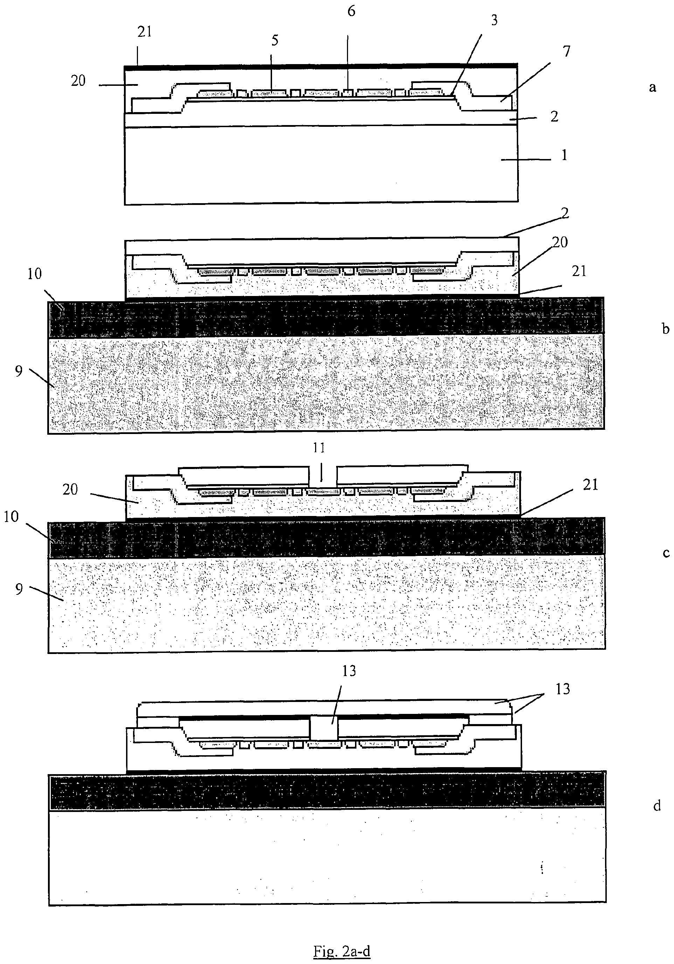

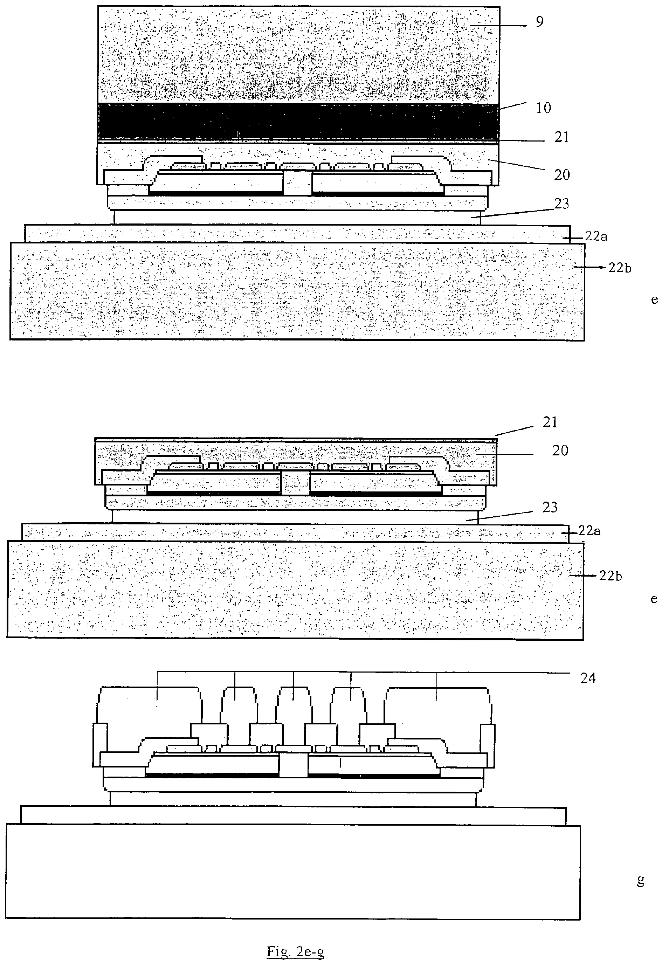

According to the invention, a number of additional steps are performed, as illustrated in figure 2.

Fig. 2a : The same steps as desbribed above are applied to obtain the gate source and drain contact zones 5 and 6 on the substrate 1. A passivation layer 20 is deposited on the contacts 5 and 6, with an etch stop 21 layer on top of the passivation layer.

Fig. 2b : the substrate 1 is reversed and bonded to the second substrate 9, after which the first substrate 1 is removed, in the same way as in the first embodiment. The bonding layer 10 according to this embodiment is not necessarily a thermally conductive adhesive layer. It may be SU8/BCB or metal.

Fig. 2c : vias 11 are etched to the contact areas. In principle, vias to only the source contacts would be enough in this case, but the disadvantage here then is that the devices cannot be measured before bonding to the third substrate. In the preferred case of this embodiment, therefore, vias are produced to all contact areas (source, drain, gate), as in figure 3.

Fig. 2d : the interconnect is established by the backside contact layer 13. The device shown in figure 2d therefore corresponds to the finished device from the first embodiment, shown in figure 1k, except that in the first embodiment there is a thermal and electrical lateral contact between the backside contact layer 13 and the second substrate 9. This contact is not present in the second embodiment, since the second substrate will be removed anyway (see further).

Fig. 2e : according to the second embodiment, a third subtrate 22a, 22b is now provided, preferably an MCM-substrate (e.g. an AIN-substrate) with a good thermal conductivity. The bottom layer 22a is the substrate and the layer 22b on top is a patterned metal layer to make contact to the sources. The third substrate is provided with a bonding layer 23. The second substrate is now reversed and attached to the third substrate by attaching the side carrying the interconnect layer 13, to the third substrate, by means of the bonding layer 23. The bonding layer 23 is preferably a layer with good thermal conductivity. It may be a metal bonding layer.

Fig. 2f : The second substrate 9 and adhesive layer 10 are subsequently removed. This may be done by an etching step, stopped by the etch stop layer 21. Other ways of removing the second substrate 9 may however be applied, which would not require an etch stop layer.

Fig. 2g : the etch stop layer is removed and vias may be etched in the passivation layer 20 on top of the gate/source/drain contacts (5,6), and heat sinks 24 may be deposited on top of the contacts.

Preferably according to the invention, the first substrate 1 is not diced before reversing and attaching it to the second substrate. In stead, the first substrate is reversed and attached as a whole, possibly attaching several HEMT-devices to the second substrate. The dicing is preferably done after reversing and attaching the first substrate to the second. As shown in figure 2e, individual devices are then reversed and attached to the third substrate.

The method of the invention provides some additional advantages over the prior art. Heat removal can be obtained both on the front and the backside of the device. At the back side, the heat can be removed to the third substrate 22 through the adhesive layer 23 and interconnect layer 13, while at the front side, heat sinks can be produced, for further improving the efficiency of the heat removal. With the device produced according to the second embodiment, it is also possible to test the complete device (with source contacts) before the integration of the HEMT in a circuit on the third substrate.

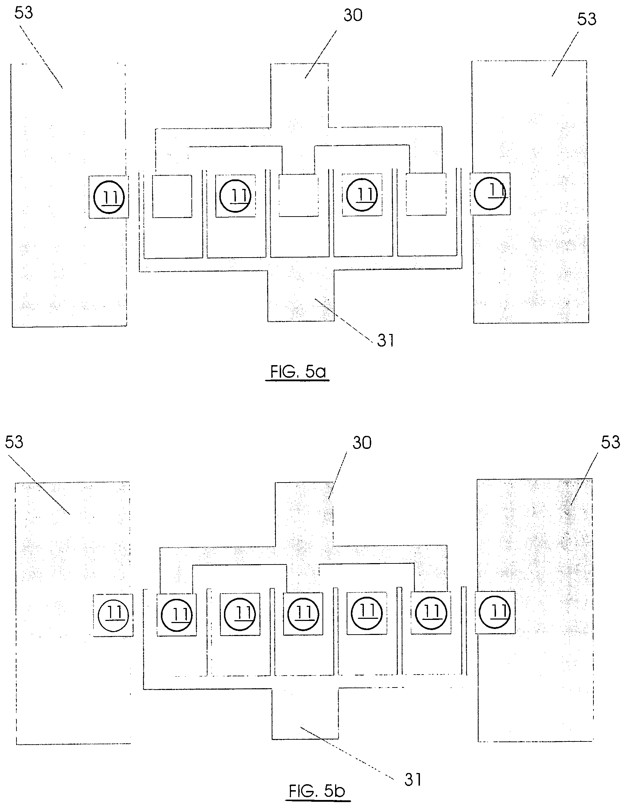

In the method according to the invention, it is possible to produce the vias to the ohmic regions in the way shown in figure 5a and 5b, i.e. without producing vias 52 to the lateral contact pads 30 and 31. This is because these areas can be contacted in a known way, and without using air bridges, after the device has been attached to the third substrate.

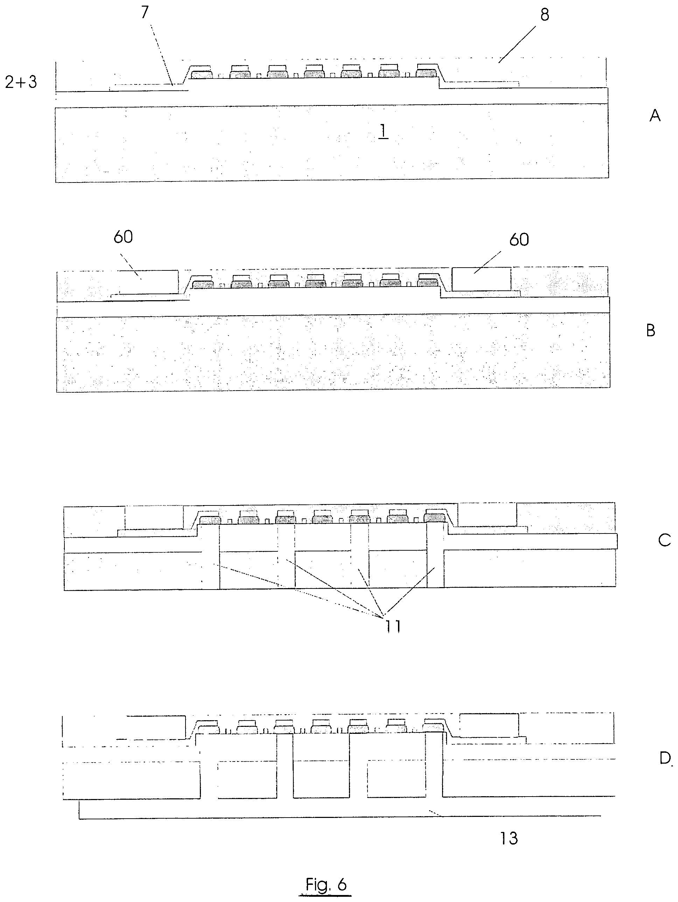

According to an example not falling within the scope of the claimed invention, the first substrate is not flipped onto a second substrate, but the vias are etched through the backside of the first substrate itself, see figure 6. This is possible only with a first substrate 1 made of particular materials, preferably a Si. On top of the Si, there is also a further semiconductor layer (2,3), e.g. GaN/AIGaN, as in the previous embodiments. The layer 2+3 is shown as one layer in fig. 6, but this is preferably a double layer as in fig. 1. As seen in figure 6a, the device, including all the gate/drain/source contacts 7 and the passivation layer 8 is produced on the first substrate, in the same way as described above for embodiment 1. Vias 60 are etched through the passivation layer 8, to contact the lateral contact pads), see fig. 6b. In this example, the vias 11 are produced through the Si-substrate 1 and the semiconductor layer 2,3 (see figure 6c). Possibly, the substrate may be thinned at the backside, before producing the vias. This is the case in the example shown : the thickness of the substrate 1 has been reduced in between the views B and C. The thinning may be performed by etching back the substrate, or by grinding and/or polishing the substrate from the backside. The interconnect layer 13 is applied onto the backside of the substrate, leading to a finished device, see figure 6.

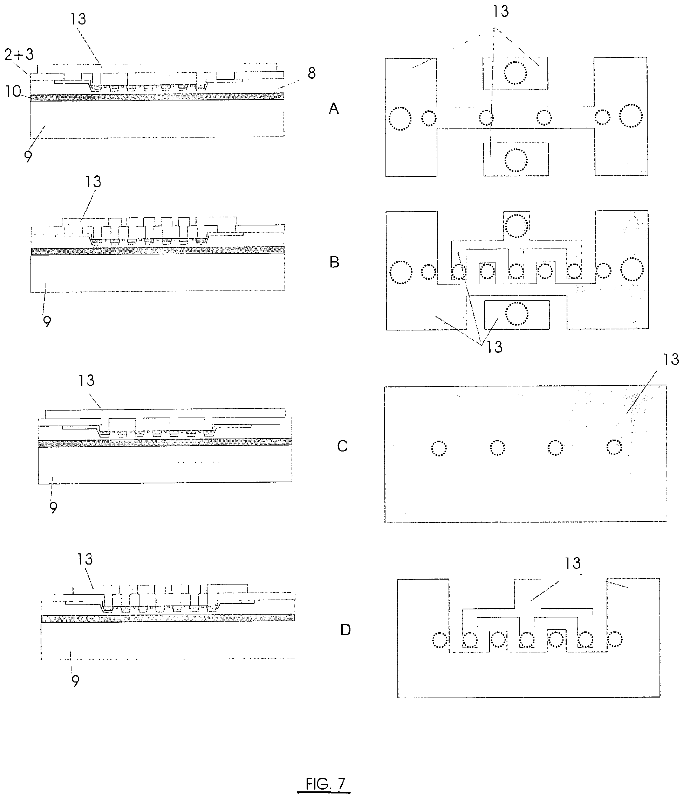

As mentioned above, the interconnect layer 13 is to be patterned in a proper way, to allow the ohmic contacts to be interconnected correctly. Figure 7 shows some examples of how this patterning may be done, in the case of the 6-gate HEMT shown in figure 4. Figure 7a and 7b show two possibilities which can be used in a device according to embodiment 1. The interconnect layer 13 shows three distinct regions, and thus allows a common contact to the gates, drains and sources respectively. Figure 7c and 7d show one or two distinct regions on the interconnect layer 13. This design is only usable in embodiment 2, as it requires one or two additional contact layers to be applied to the front of the device, after the device has been attached to the third substrate (fig. 2).

## Claims

1. A method for producing a semiconductor device comprising a plurality of groups consisting of a source, drain and gate contact, wherein the respective types of contact of said groups are interconnected to a common gate, drain and source contact, said method comprising the step of :
- providing a first substrate (1), comprising on its front side a semiconductor layer (2,3), and on top of that layer (2,3), i.e. on the front side of said layer, a plurality of gate contacts (6), each gate contact lying in between source and drain ohmic contacts (5),
**characterized in that** the method further comprises the steps of:
- providing a second substrate (9) provided with an adhesive layer (10),
- attaching the first substrate to the second, by attaching the front side of said first substrate, including said gate/source/drain, to said adhesive layer (10) of the second substrate (9),
- after the step of attaching the first substrate, removing the first substrate (1) from the semiconductor layer (2,3), to expose the backside of the semiconductor layer (2,3),
- after the step of removing the first substrate, etching vias (11) through the backside of said semiconductor layer, wherein vias are produced directly on top of each contact of at least one type, to thereby expose said contacts,
- after the step of producing vias (11), producing on the backside of said semiconductor layer an interconnecting contact layer (13) to provide an interconnect between said source-gate-drain groups to form a common gate, drain and source output contact respectively, this resulting in a semiconductor device on the second substrate,
- providing a third substrate (22a,22b) provided with a bonding layer (23),
- attaching the second substrate (9) to the third substrate, by attaching the side of the second substrate, including said semiconductor device, to said bonding layer (23) on the third substrate,
- removing the second substrate (9) and the adhesive layer (10), this resulting in a semiconductor device on the third substrate.

2. The method according to claim 1, wherein said semiconductor device is a multiple gate-finger HEMT.

3. The method according to claim 1 or 2, wherein vias (11) are produced directly on top of all the source contacts (29), and wherein vias (11) are also produced directly on top of all the drain contacts (50).

4. A method for producing a semiconductor device comprising a plurality of groups of an emitter, base and collector contact, wherein the respective types of contact of said groups are interconnected to a common base, collector, emitter contact, said method comprising the step of :
- providing a first substrate (1), comprising on its front side a semiconductor layer (2,3), and on top of that layer (2,3), i.e. on the front side of said layer, a plurality of base contacts (6), each base contact lying in between emitter and collector ohmic contacts,
**characterized in that** the method further comprises the steps of:
- providing a second substrate (9) provided with an adhesive layer (10),
- attaching the first substrate to the second, by attaching the front side of said first substrate, including said base/emitter/collector contacts, to said adhesive layer (10) of the second substrate (9),
- after the step of attaching the first substrate, removing the first substrate (1) from the semiconductor layer (2,3), to expose the backside of the semiconductor layer (2,3),
- after the step of removing the first substrate, etching vias (11) through the backside of said semiconductor layer, wherein vias are produced directly on top of each contact of at least one type, to thereby expose said contacts,
- after the step of producing vias (11), producing on the backside of said semiconductor layer an interconnecting contact layer (13) to provide an interconnect between said emitter-base-collector groups to form a common gate, drain and source output contact respectively, this resulting in a semiconductor device on the second substrate,
- providing a third substrate (22a,22b) provided with a bonding layer (23),
- attaching the second substrate (9) to the third substrate, by attaching the side of the second substrate, including said semiconductor device, to said bonding layer (23) on the third substrate,
- removing the second substrate (9) and the adhesive layer (10), this resulting in a semiconductor device on the third substrate.

5. The method according to claim 4, wherein said semiconductor device is a multiple base bipolar transistor.

6. The method according to claim 4 or 5, wherein vias (11) are produced directly on top of all the emitter contacts, and wherein vias (11) are also produced directly on top of all the collector contacts.

7. The method according to any one of the preceding claims, wherein vias are produced on top of all the contacts of one type, the semiconductor device comprises lateral contact areas (30,31), wherein the contacts of each of the other types are produced in such a way that they are interconnected to respective lateral contact areas (30,31), by vias which are not directly on top of the actual ohmic contacts.

8. The method according to claim 7, wherein vias (52,54) are produced through the backside of the semiconductor layer (2,3), on top of said lateral areas (30,31).

9. The method according to any one of claims 1 to 8, wherein said adhesive layer (10) consists of a thermally conductive adhesive layer material selected from the group consisting of organic polymers, thermally conductive epoxy e.g. epoxies with fillers, SU-8, polyimide, BCB, silicones, flowable oxides.

10. The method according to any one of claims 1 to 9, further comprising the step of applying a contact metal layer (7) onto said contacts (5,6), prior to attaching the first substrate to the second.

11. The method according to any one of claims 1 to 10, further comprising the step of applying a passivation and heat spreading layer (8) onto said contacts (5,6) or onto said contact metal layer (7), prior to attaching the first substrate to the second.

12. The method according to claim 11, wherein said passivation and heat spreading layer consists of AIN, AlSiC, SiC or Si-nitride.

13. The method according to any one of claims 1 to 12, wherein a passivation layer is applied onto said contacts, and a heat spreading layer is applied onto said passivation layer.

14. The method according to any one of claims 1 to 13, further comprising the step of applying a passivation layer (12) on the backside of the semiconductor layer (2,3), after the step of producing vias (11) in the semiconductor layer, and before the step of producing the interconnecting contact layer (13).

15. The method according to any one of claims 1 to 14, wherein said vias (11) are produced for contacting only one type of contact.

16. The method according to any one of claims 1 to 15, wherein said second substrate (9) is diced to form individual devices, before the second substrate, in the form of these individual devices, is attached to the third (22a,22b).

17. The method according to any one of the preceding claims, wherein said semiconductor layer (2,3) consists of a stack of a GaN layer and an AIGaN layer.

## Patentansprüche

1. Verfahren zur Herstellung einer Halbleitervorrichtung, umfassend eine Mehrzahl Gruppen, die aus einem Source-, einem Drain- und einem Gate-Kontakt bestehen, wobei die jeweiligen Arten von Kontakten dieser Gruppen mit einem gemeinsamen Gate-, Drain- und Source-Kontakt verbunden sind, wobei das Verfahren den Schritt umfasst:
- Vorsehen eines ersten Substrats (1), umfassend auf dessen Vorderseite eine Halbleiterschicht (2, 3) und auf dieser Schicht (2, 3), d.h. auf der Vorderseite der Schicht, eine Mehrzahl Gate-Kontakte (6), wobei jeder Gate-Kontakt zwischen ohmschen Source- und Drain-Kontakten (5) liegt,
**dadurch gekennzeichnet, dass** das Verfahren ferner die Schritte umfasst:
- Vorsehen eines zweiten Substrats (9), das mit einer Klebstoffschicht (10) versehen ist,
- Befestigen des ersten Substrats an das zweite durch Befestigen der Vorderseite des ersten Substrats, die den Gate-/Source-/Drain-Kontakt umfasst, an die Klebstoffschicht (10) des zweiten Substrats (9),
- im Anschluss an den Schritt des Befestigens des ersten Substrats: Entfernen des ersten Substrats (1) von der Halbleiterschicht (2, 3) um die Rückseite der Halbleiterschicht (2, 3) freizulegen,
- im Anschluss an den Schritt des Entfernen des ersten Substrats: Einätzen von Durchkontaktierungen (11) durch die Rückseite der Halbleiterschicht, wobei Durchkontaktierungen unmittelbar auf jedem Kontakt mindestens einer Art erzeugt werden, um so die Kontakte freizulegen,
- im Anschluss an den Schritt des Erzeugens von Durchkontaktierungen (11): Erzeugen einer verbindenden Kontaktschicht (13) auf der Rückseite der Halbleiterschicht, um eine Verbindung zwischen den Source-Gate-Drain-Gruppen zu bilden, um jeweils einen gemeinsamen Gate-, Drain- bzw. Source-Ausgangskontakt zu bilden, was eine Halbleitervorrichtung auf dem zweiten Substrat ergibt,
- Vorsehen eines dritten Substrats (22a, 22b), das mit einer Bindeschicht (23) versehen ist,
- Befestigen des zweiten Substrats (9) an das dritte Substrat durch Befestigen der Seite des zweiten Substrats, die die Halbleitervorrichtung umfasst, an die Bindeschicht (23) auf dem dritten Substrat,
- Entfernen des zweiten Substrats (9) und der Klebstoffschicht (10), was eine Halbleitervorrichtung auf dem dritten Substrat ergibt.

2. Verfahren nach Anspruch 1, wobei die Halbleitervorrichtung ein Multiple-Gate-Finger-HEMT ist.

3. Verfahren nach Anspruch 1 oder 2, wobei Durchkontaktierungen (11) unmittelbar auf allen Source-Kontakten (29) erzeugt werden, und wobei Durchkontaktierungen (11) auch unmittelbar auf allen Drain-Kontakten (50) erzeugt werden.

4. Verfahren zur Herstellung einer Halbleitervorrichtung, umfassend eine Mehrzahl Gruppen, die aus einem Emitter-, einem Basis- und einem Kollektor-Kontakt bestehen, wobei die jeweiligen Arten von Kontakten dieser Gruppen mit einem gemeinsamen Basis-, Kollektor- und Emitter-Kontakt verbunden sind, wobei das Verfahren den Schritt umfasst:
- Vorsehen eines ersten Substrats (1), umfassend auf dessen Vorderseite eine Halbleiterschicht (2, 3) und auf dieser Schicht (2, 3), d.h. auf der Vorderseite der Schicht, eine Mehrzahl Basis-Kontakte (6), wobei jeder Basis-Kontakt zwischen ohmschen Emitter- und Kollektor-Kontakten liegt,
**dadurch gekennzeichnet, dass** das Verfahren ferner die Schritte umfasst:
- Vorsehen eines zweiten Substrats (9), das mit einer Klebstoffschicht (10) versehen ist,
- Befestigen des ersten Substrats an das zweite durch Befestigen der Vorderseite des ersten Substrats, die die Basis-/Emitter-/Kollektor-Kontakte umfasst, an die Klebstoffschicht (10) des zweiten Substrats (9),
- im Anschluss an den Schritt des Befestigens des ersten Substrats: Entfernen des ersten Substrats (1) von der Halbleiterschicht (2, 3) um die Rückseite der Halbleiterschicht (2, 3) freizulegen,
- im Anschluss an den Schritt des Entfernen des ersten Substrats: Einätzen von Durchkontaktierungen (11) durch die Rückseite der Halbleiterschicht, wobei Durchkontaktierungen unmittelbar auf jedem Kontakt mindestens einer Art erzeugt werden, um so die Kontakte freizulegen,
- im Anschluss an den Schritt des Erzeugens von Durchkontaktierungen (11): Erzeugen einer verbindenden Kontaktschicht (13) auf der Rückseite der Halbleiterschicht, um eine Verbindung zwischen den Emitter-Basis-Kollektor-Gruppen zu bilden, um jeweils einen gemeinsamen Gate-, Drain- bzw. Source-Ausgangskontakt zu bilden, was eine Halbleitervorrichtung auf dem zweiten Substrat ergibt,
- Vorsehen eines dritten Substrats (22a, 22b), das mit einer Bindeschicht (23) versehen ist,
- Befestigen des zweiten Substrats (9) an das dritte Substrat durch Befestigen der Seite des zweiten Substrats, die die Halbleitervorrichtung umfasst, an die Bindeschicht (23) auf dem dritten Substrat,
- Entfernen des zweiten Substrats (9) und der Klebstoffschicht (10), was eine Halbleitervorrichtung auf dem dritten Substrat ergibt.

5. Verfahren nach Anspruch 4, wobei die Halbleitervorrichtung ein Mehrfachbasis-Bipolartransistor ist.

6. Verfahren nach Anspruch 4 oder 5, wobei Durchkontaktierungen (11) unmittelbar auf allen Emitter-Kontakten erzeugt werden, und wobei Durchkontaktierungen (11) auch unmittelbar auf allen Kollektor-Kontakten (50) erzeugt werden.

7. Verfahren nach einem der vorstehenden Ansprüche,
wobei Durchkontaktierungen auf allen Kontakten einer Art erzeugt werden, die Halbleitervorrichtung seitliche Kontaktbereiche (30, 31) umfasst, wobei die Kontakte jeder der anderen Arten derart erzeugt werden, dass sie mit jeweiligen seitlichen Kontaktbereichen (30, 31) über Durchkontaktierungen, die nicht unmittelbar auf den eigentlichen ohmschen Kontakten aufliegen, verbunden sind.

8. Verfahren nach Anspruch 7, wobei Durchkontaktierungen (52, 54) durch die Rückseite der Halbleiterschicht (2, 3) auf den seitlichen Bereichen (30, 31) erzeugt werden.

9. Verfahren nach einem der Ansprüche 1 - 8, wobei die Klebstoffschicht (10) aus einem wärmeleitenden Material besteht, das aus der nachfolgenden Gruppe gewählt ist: organische Polymere, wärmeleitendes Epoxid, z.B. Epoxide mit Füllstoffen, SU-8, Polyimid, BCB, Silikone, fließfähige Oxide.

10. Verfahren nach einem der Ansprüche 1 - 9, ferner umfassend den Schritt des Anwendens einer Kontaktmetallschicht (7) auf die Kontakte (5, 6) vor dem Befestigen des ersten Substrats an das zweite.

11. Verfahren nach einem der Ansprüche 1 - 10, ferner umfassend den Schritt des Anwendens einer Passivierungs- und Wärmeausbreitungsschicht (8) auf die Kontakte (5, 6) oder auf die Kontaktmetallschicht (7) vor dem Befestigen des ersten Substrats an das zweite.

12. Verfahren nach Anspruch 11, wobei die Passivierungs- und Wärmeausbreitungsschicht aus AlN, AlSiC, SiC oder Si-Nitrid besteht.

13. Verfahren nach einem der Ansprüche 1 - 12, wobei eine Passivierungsschicht auf die Kontakte angewendet wird und eine Wärmeausbreitungsschicht auf die Passivierungsschicht angewendet wird.

14. Verfahren nach einem der Ansprüche 1 - 13, ferner umfassend den Schritt des Anwendens einer Passivierungsschicht (12) auf die Rückseite der Halbleiterschicht (2, 3) im Anschluss an den Schritt des Erzeugens von Durchkontaktierungen (11) in der Halbleiterschicht und vor dem Schritt des Erzeugens der verbindenden Kontaktschicht (13).

15. Verfahren nach einem der Ansprüche 1 - 14, wobei die Durchkontaktierungen (11) erzeugt werden, um einen Kontakt nur einer Art zu kontaktieren.

16. Verfahren nach einem der Ansprüche 1 - 15, wobei das zweite Substrat (9) gewürfelt ist, um einzelne Vorrichtungen zu bilden, bevor das zweite Substrat in Form dieser einzelnen Vorrichtungen an das dritte (22a, 22b) angebunden wird.

17. Verfahren nach einem der vorstehenden Ansprüche, wobei die Halbleiterschicht (2, 3) aus einem Stapel aus einer GaN- und einer AlGaN-Schicht besteht.

## Revendications

1. Procédé pour produire un dispositif à semi-conducteurs comprenant une pluralité de groupes consistant en un contact de source, de drain et de grille, dans lequel les types respectifs de contacts desdits groupes sont interconnectés à un contact de grille, de drain et de source commun, ledit procédé comprenant l'étape :
- de fourniture d'un premier substrat (1), comprenant, sur sa face avant, une couche semi-conductrice (2, 3), et au-dessus de cette couche (2, 3), c'est-à-dire sur la face avant de ladite couche, une pluralité de contacts de grille (6), chaque contact de grille se trouvant entre des contacts ohmiques de source et de drain (5),
**caractérisé en ce qu'**il comprend en outre les étapes de:
- fourniture d'un deuxième substrat (9) pourvu d'une couche adhésive (10),
- fixation du premier substrat au deuxième substrat, en attachant la face avant dudit premier substrat, comprenant lesdits grille/source/drain, à ladite couche adhésive (10) du deuxième substrat (9),
- après l'étape de fixation du premier substrat, retirer du premier substrat (1) de la couche semi-conductrice (2, 3), exposer la face arrière de la couche semi-conductrice (2, 3),
- après l'étape de retrait du premier substrat, de gravure de trous d'interconnexion (11) à travers la face arrière de ladite couche semi-conductrice, dans lequel les trous d'interconnexion sont produits directement au-dessus de chaque contact d'au moins un type, exposer de ce fait lesdits contacts,
- après l'étape de production de trous d'interconnexion (11), produire, sur la face arrière de ladite couche semi-conductrice, une couche de contacts d'interconnexion (13) pour réaliser une interconnexion entre lesdits groupes de source-grille-drain pour former un contact commun de sortie de grille, de drain et de source respectivement, ceci résultant en un dispositif à semi-conducteurs sur le deuxième substrat,
- fourniture d'un troisième substrat (22a, 22b) pourvu d'une couche de liaison (23),
- fixation du deuxième substrat (9) au troisième substrat, en attachant la face du deuxième substrat, comprenant ledit dispositif à semi-conducteurs, à ladite couche de liaison (23) sur le troisième substrat,
- retirer le deuxième substrat (9) et la couche adhésive (10), ceci résultant en un dispositif à semi-conducteurs sur le troisième substrat.

2. Procédé selon la revendication 1, dans lequel ledit dispositif à semi-conducteurs est un HEMT à multiples grilles-doigts.

3. Procédé selon la revendication 1 ou 2, dans lequel les trous d'interconnexion (11) sont produits directement au-dessus de tous les contacts de source (29), et dans lequel les trous d'interconnexion (11) sont également produits directement au-dessus de tous les contacts de drain (50).

4. Procédé pour produire un dispositif à semi-conducteurs comprenant une pluralité de groupes d'un contact d'émetteur, de base et de collecteur, dans lequel les types respectifs de contacts desdits groupes sont interconnectés à un contact commun de base, de collecteur, d'émetteur, ledit procédé comprenant l'étape de:
- fourniture d'un premier substrat (1), comprenant, sur sa face avant, une couche semi-conductrice (2, 3), et au-dessus de cette couche (2, 3), c'est-à-dire sur la face avant de ladite couche, une pluralité de contacts de base (6), chaque contact de base se trouvant entre des contacts ohmiques d'émetteur et de collecteur,
**caractérisé en ce qu'**il comprend en outre les étapes :
- fourniture d'un deuxième substrat (9) pourvu d'une couche adhésive (10),
- fixation du premier substrat au deuxième substrat, en attachant la face avant dudit premier substrat, comprenant lesdits contacts de base/émetteur/collecteur, à ladite couche adhésive (10) du deuxième substrat (9),
- après l'étape de fixation du premier substrat, retirer du premier substrat (1) de la couche semi-conductrice (2, 3), pour exposer la face arrière de la couche semi-conductrice (2, 3),
- après l'étape de retrait du premier substrat, de gravure de trous d'interconnexion (11) à travers la face arrière de ladite couche semi-conductrice, dans lequel les trous d'interconnexion sont produits directement au-dessus de chaque contact d'au moins un type, exposer de ce fait lesdits contacts,
- après l'étape de production de trous d'interconnexion (11), produire, sur la face arrière de ladite couche semi-conductrice, d'une couche de contacts d'interconnexion (13) pour réaliser une interconnexion entre lesdits groupes d'émetteur-base-collecteur pour former un contact commun de sortie de grille, de drain et de source respectivement, ceci résultant en un dispositif à semi-conducteurs sur le deuxième substrat,
- fourniture d'un troisième substrat (22a, 22b) pourvu d'une couche de liaison (23),
- fixation du deuxième substrat (9) au troisième substrat, en attachant la face du deuxième substrat, comprenant ledit dispositif à semi-conducteurs, à ladite couche de liaison (23) sur le troisième substrat,
- retirer le deuxième substrat (9) et de la couche adhésive (10), ceci résultant en un dispositif à semi-conducteurs sur le troisième substrat.

5. Procédé selon la revendication 4, dans lequel ledit dispositif à semi-conducteurs est un transistor bipolaire à multiples bases.

6. Procédé selon la revendication 4 ou 5, dans lequel les trous d'interconnexion (11) sont produits directement au-dessus de tous les contacts d'émetteur, et dans lequel les trous d'interconnexion (11) sont également produits directement au-dessus de tous les contacts de collecteur.

7. Procédé selon l'une quelconque des revendications précédentes, dans lequel les trous d'interconnexion sont produits au-dessus de tous les contacts d'un type, le dispositif à semi-conducteurs comprenant des zones de contact latérales (30, 31), dans lequel les contacts de chacun des autres types sont produits d'une manière telle qu'ils sont interconnectés à des zones de contact latérales (30, 31) respectives, par des trous d'interconnexion qui ne sont pas directement au-dessus des contacts ohmiques réels.

8. Procédé selon la revendication 7, dans lequel les trous d'interconnexion (52, 54) sont produits à travers le côté arrière de la couche semi-conductrice (2, 3), au-dessus desdites zones latérales (30, 31).

9. Procédé selon l'une quelconque des revendications 1 à 8, dans lequel ladite couche adhésive (10) consiste en un matériau de couche adhésive thermoconducteur sélectionné dans le groupe consistant en des polymères organiques, un époxy thermoconducteur par exemple des époxys avec des excipients, du SU-8, un polyimide, du BCB, des silicones, des oxydes fluidisables.

10. Procédé selon l'une quelconque des revendications 1 à 9, comprenant en outre l'étape d'application d'une couche de métal de contact (7) sur lesdits contacts (5, 6), avant la fixation du premier substrat au deuxième substrat.

11. Procédé selon l'une quelconque des revendications 1 à 10, comprenant en outre l'étape d'application d'une couche de passivation et de dispersion de chaleur (8) sur lesdits contacts (5, 6) ou sur ladite couche de métal de contact (7), avant la fixation du premier substrat au deuxième substrat.

12. Procédé selon la revendication 11, dans lequel ladite couche de passivation et de dispersion de chaleur consiste en de l'AlN, de l'AlSiC, du SiC ou du Si-nitrure.

13. Procédé selon l'une quelconque des revendications 1 à 12, dans lequel une couche de passivation est appliquée sur lesdits contacts, et une couche de dispersion de chaleur est appliquée sur ladite couche de passivation.

14. Procédé selon l'une quelconque des revendications 1 à 13, comprenant en outre l'étape d'application d'une couche de passivation (12) sur la face arrière de la couche semi-conductrice (2, 3), après l'étape de production de trous d'interconnexion (11) dans la couche semi-conductrice, et avant l'étape de production de la couche de contacts d'interconnexion (13) .

15. Procédé selon l'une quelconque des revendications 1 à 14, dans lequel lesdits trous d'interconnexion (11) sont produits pour être en contact avec un seul type de contact.

16. Procédé selon l'une quelconque des revendications 1 à 15, dans lequel ledit substrat (9) est découpé pour former des dispositifs individuels, avant que le deuxième substrat, sous la forme de ces dispositifs individuels, soit attaché au troisième substrat (22a, 22b).

17. Procédé selon l'une quelconque des revendications précédentes, dans lequel ladite couche semi-conductrice (2, 3) consiste en un empilement d'une couche de GaN et d'une couche d'AlGaN.
